Europäisches Patentamt

European Patent Office

Office européen des brevets

(19)

(11) EP 0 845 819 A1

(12) **EUROPEAN PATENT APPLICATION**

(43) Date of publication:
03.06.1998 Bulletin 1998/23

(51) Int Cl.⁶: **H01L 33/00**, H01L 31/0216, H01S 3/025, G02B 1/10

(21) Application number: 97309506.0

(22) Date of filing: 25.11.1997

(84) Designated Contracting States:
AT BE CH DE DK ES FI FR GB GR IE IT LI LU MC NL PT SE
Designated Extension States:
AL LT LV MK RO SI

(30) Priority: 27.11.1996 US 757183

(71) Applicant: LUCENT TECHNOLOGIES INC.
Murray Hill, New Jersey 07974-0636 (US)

(72) Inventors:
• Chakrabarti, Utpal Kumar
Allentown, Pennsylvania 18104 (US)

• Wang, Kou-Wei
Orefield, Pennsylvania 18069 (US)
• Dautremont-Smith, William Crossley
Orefield, Pennsylvania 18069 (US)
• Wilt, Daniel Paul
Orefield, Pennsylvania 18069 (US)

(74) Representative: Johnston, Kenneth Graham et al
Lucent Technologies (UK) Ltd,
5 Mornington Road
Woodford Green Essex, IG8 OTU (GB)

(54) **Yttrium aluminum oxide coatings for active semiconductor optical devices**

(57) An hermetically packaged active semiconductor optical device (10) includes a coating (14) comprising an oxide of yttrium and aluminum. The coating may function, for example, as a reflection-modifying coating and/or as a passivation coating. Applications to semiconductor lasers are specifically described.

*FIG. 1*

EP 0 845 819 A1

## Description

## Background of the Invention

This invention relates to coatings for semiconductor devices, and, more particularly, to reflection-modifying and/or passivation coatings for active semiconductor optical devices in hermetic packages.

Dielectric coatings, layers, regions, and the like serve many purposes in active semiconductor devices. For example, they may perform an insulating function, a passivating function, a reflection-modifying function, or any combination of the three. In the field of active optical devices in particular, reflection-modifying dielectric coatings have been used to enhance the performance of LEDs, lasers, and photodetectors. Thus, low-reflection (LR) coatings (e.g., 1-5% reflectivity) have been used on the output facet of Fabry-Perot lasers to increase their quantum efficiency, and anti-reflection (AR) coatings (e.g., <1% reflectivity) have been used on the output facet of distributed feedback (DFB) lasers to suppress Fabry-Perot modes and induce single longitudinal mode emission.

Usually the device design specifies that the coating reflectivity should fall within a relatively tight range of acceptable reflectivities to allow for expected variations in other aspects of the manufacturing process. For high yields it is clearly desirable to minimize the device-to-device variation in the reflectivity of the coating. The coating reflectivity, in turn, is a function of its thickness $t_c$ as well as its refractive index $n_c$ in relation to the effective refractive index $n_{eff}$ of the substrate (i.e., any supporting surface or body) on which the coating is formed. Take, for example, the simplest form of reflection-modifying coating - a single layer, dielectric coating deposited on a substrate. It is well known that minimum reflectivity $R_{min}$ is obtained when the coating thickness is equal to the quarter wave thickness $t_{qw}$ (or an odd multiple thereof); that is,

$$R_{min} = \left( \frac{n_c - \sqrt{n_{eff}}}{n_c + \sqrt{n_{eff}}} \right)^2 \qquad (1)$$

when

$$t_c = t_{qw} = m\lambda/4n_c \qquad (2)$$

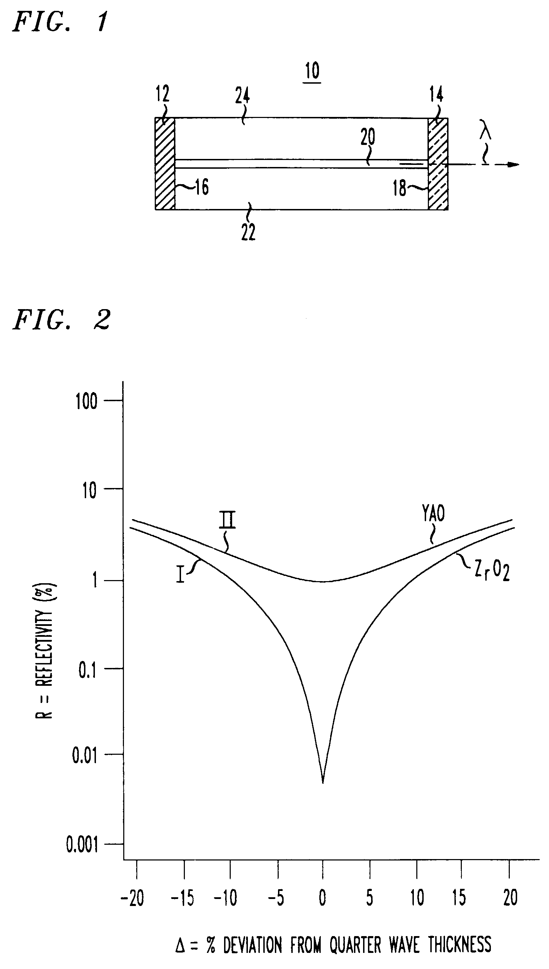

where $\lambda$ is the operating wavelength of the device as measured in a vacuum, and $\underline{m}$ is a positive, odd integer. However, as the actual thickness of a typical prior art coating deviates from $t_{qw}$, its reflectivity changes dramatically. Curve I of FIG. 2 illustrates the extreme sensitivity of the reflectivity R of a typical $ZrO_2$ coating to thickness deviations $\Delta$ from $t_{qw}$. As noted earlier, minimum reflectivity (e.g., < 0.01%) is obtained at $\Delta = 0$

(where $t_c = t_{qw}$), and if the acceptable thickness range is centered at $t_{qw}$, the symmetry of Curve I enhances yield somewhat. Unfortunately, this advantage is more than offset by the large slope of Curve I on either side of $t_{qw}$. Thus, as the thickness deviates from $t_{qw}$ in either direction, the reflectivity R changes dramatically. Even if the reflectivity of the prior art coating is centered around a thickness other than that which produces minimum reflectivity, say at R = 1%, the slope of Curve I in that region is still very large. Thus, if a particular application requires tight manufacturing control of reflectivity around a value of R = 1%, a coating which produces a relatively flat reflectivity vs. thickness curve, as in Curve II, is much more desirable than one which produces the steep slopes of Curve I. In other words, for Curve I, normal deviations in thickness resulting from typical manufacturing process variations cause many devices to fall outside of the application requirement. Simply put, yields suffer.

## Summary of the Invention

In accordance with one aspect of our invention, an active semiconductor optical device includes a coating which comprises an oxide of yttrium and aluminum (YAO). The active optical device illustratively comprises a semiconductor laser in which the YAO coating modifies the reflectivity of an output facet.

In a preferred embodiment of such a semiconductor laser, the YAO coating serves an LR function, and the sensitivity of its reflectivity to thickness variations is relatively low.

## Brief Description of the Drawings

Our invention, together with its various features and advantages, can be readily understood from the following more detailed description taken in conjunction with the accompanying drawing in which:

FIG. 1 is a schematic view of an hermetically packaged active semiconductor optical device in accordance with one aspect of our invention. In the interest of clarity, this figure has not been drawn to scale; and

FIG. 2 is a graph of reflectivity R versus percent thickness deviation $\Delta$ from $t_{qw}$ for a typical prior art $ZrO_2$ coating (Curve I) and for a YAO coating (Curve II) in accordance with a semiconductor laser embodiment of our invention. This figure is drawn on a semi-log scale because the emission wavelength and the lasing threshold of the laser are both related to $ln$R, which, in turn, means that fractional or percent changes in reflectivity (as opposed to absolute changes) should be controlled.

## Detailed Description

Turning now to FIG. 1, we show an active semiconductor optical device 10 (or a portion thereof) which, by way of example, may be a laser, an LED, a modulator or a photodetector. Device 10 may have one or more dielectric coatings 12, 14, formed on one or more surfaces, or facets 16, 18. The coatings 12, 14 may serve to modify the reflectivity of the surfaces, to passivate them, or both. Illustratively, device 10 comprises a compound semiconductor material such as a Group III-V compound material. Moreover, device 10 may comprise a complex, multilayered structure including layers of different semiconductor materials, e.g., layers of InP and InGaAsP. For purposes of exposition, and without limitation, we will describe device 10 hereinafter as an InP-InGaAsP Fabry-Perot laser in which case one of the coatings is a high reflectivity (HR) coating 12 and the other is a low reflectivity (LR) coating 14. Illustratively, the HR coating 12 is a multilayered coating, whereas the LR coating 14 is a single layer coating.

The basic laser structure is well known in the art; it comprises a relatively narrow bandgap active region 20 disposed between a pair of wider bandgap InP cladding regions 22 and 24. Region 20 itself may comprise a single layer (e.g., of InGaAsP) or multiple layers (e.g., a multi-quantum well structure). An HR coating 12 is formed on one laser facet, and an LR coating 14 is formed on the other. Not shown, but also well known, are electrical contacts used to provide forward bias, sufficient drive current to cause the active region to emit radiation $\lambda$ primarily through the LR coating 14 to a utilization device not shown (e.g., an optical fiber, a photodetector etc.) and an hermetic package enclosing the laser. Some radiation will also emerge through HR coating 12, and as is conventional in the art, this "back-face" emission may be directed to a monitor photodiode arrangement (not shown) used to control certain aspects of laser operation (e.g., its bias or operating point).

Typically, HR coating 12 is a multilayered coating comprising alternating layers of high and low refractive index dielectric materials. The number of pairs of such layers, the index difference between the layers, and their thickness determine the reflectivity of the HR coating, as is well known in the art. Illustratively the HR coating comprises alternating layers of Si and $Y_2O_3$-doped $ZrO_2$, with the latter material deposited first on the facet. This oxide material is described in U.S. Patent No. 4,749,255 which was granted to U. K. Chakrabarti et al. on June 7, 1988.

In accordance with one aspect of our invention, the LR coating 14 is a single layer comprising an oxide of yttrium and aluminum (YAO). As deposited, the YAO layer may be amorphous or microcrystalline. Our YAO coatings exhibit several important characteristics: (1) reflectivity that is relatively insensitive to thickness variations, (2) relatively small thickness variations, and (3) controllable refractive index $n_c$. The first point is illustrated by the relative flatness of Curve II of FIG. 2. That is, the slope of Curve II is relatively low, especially in the regions near $t_{qw}$ (i.e., near $\Delta=0$). Consider the case where both $ZrO_2$ coatings (Curve I) and our YAO coatings (Curve II) are designed to have $R \simeq 0.90\%$. In our process the standard deviation is about $\pm 120$Å for $ZrO_2$ but only about $\pm 30$Å for YAO (point (2) above), so that the reflectivity of our YAO coatings again varies very little (having a one sigma variation from about 0.88 to 0.92%), whereas the reflectivity of $ZrO_2$ coatings varies by more than an order of magnitude (having a one sigma variation from about 0.15 to 2.24%).

As for the third point, Curve II of FIG. 2 represents one of a family of such curves, each separate curve corresponding to a different refractive index $n_c$. But since the refractive index of our YAO coatings is highly controllable, run-to-run variations in $n_c$ are small and hence produce relatively small variations in the position of the curves; i.e., the variability in the vertical (R) direction of Curve II due to variations in $n_c$ associated with our YAO fabrication process is small.

Other features of our YAO coatings relate to both fabrication process and device design considerations. From a design standpoint, our YAO coatings have a refractive index $n_c \simeq 1.634$, which, for use as an LR coating, is an excellent match to substrates having an effective refractive index $n_{eff} = 3.2$ (e.g., 3.23); that is, the output facets of one important class of InP-InGaAsP Fabry-Perot lasers have $n_{eff} \simeq 3.23$. In this embodiment, the substrate is a laser facet formed by the edges of multiple layers of InP and InGaAsP. Thus, $n_{eff}$ is essentially an average of the refractive indices of the layers penetrated by the transverse mode of the laser radiation.

From a processing standpoint, YAO can be deposited on various substrates, including laser facets, using conventional processes such as e-beam deposition (i.e., evaporation) or ion-assisted e-beam deposition. Moreover, the source material, which has a single phase (i.e., YAG), can be readily evaporated from a melted (or at least viscous) planar surface. These characteristics all contribute to obtaining coatings with very reproducible refractive index values and small thickness variations, both important properties which enable us to obtain reproducible reflectivity.

## Example

This example describes an InP-InGaAsP strained multi-quantum well (SMQW) high power laser having an operating wavelength of $\lambda = 1.48\mu m$. This type of laser typically delivers up to about 100 mW of optical power at its output facet and is particularly useful as a pump for Er-doped optical fiber amplifiers of signals at 1.55 $\mu m$.

The output facet of the laser, having $n_{eff} \simeq 3.23$, was coated with an LR coating of YAO having $n_c \simeq 1.634$, $t_c \simeq t_{qw} \simeq 2264$Å (at $\lambda \simeq 1.48 \mu m$), and $R \simeq 0.90\pm0.02\%$. The coating was deposited using conventional, commercially available e-beam deposition equipment in which the deposition chamber pressure was about $10^{-5}$ torr (but $3 \times 10^{-5}$ to $10^{-7}$ torr is suitable) due mainly to the presence of oxygen which we bled into the chamber. The electron gun voltage was about 7 kV (but 5-10 kV is suitable), and the deposition rate was about 2 Å/sec. (but 1-8 Å /sec. is suitable). The source was yttrium aluminum garnet which was e-beam melted to produce an essentially single phase material. During deposition, however, this source material evaporates incongruently so that $n_c$ of the deposited coating is closer to the refractive index of aluminum oxide than that of bulk YAG.

The rear facet of the laser had a multilayered HR coating comprising a single layer of $Y_2O_3$ -doped $ZrO_2$ (YSZ) on the facet and a single layer of Si on the YSZ layer. This coating had a reflectivity of about 70% at 1.48 μm.

We evaluated the optical output power asymmetry (the ratio of the optical power from the output facet to that from the back facet) which is determined mainly by the LR coating reflectivity. Measurements on thousands of these lasers from multiple coating runs demonstrated a reduction in variability over lasers with prior art $ZrO_2$ LR coatings; i.e., the asymmetry of lasers with the $ZrO_2$ coatings varied by a factor of at least 4 more than the asymmetry of lasers with our YAO coatings.

Tighter control of asymmetry produces much tighter control of other important laser characteristics such as emission wavelength, operating current at a fixed light output power, back-face monitor current, etc.

Accelerated aging of our YAO coated lasers demonstrated excellent stability characteristics. For example, aging for 1500 hours at temperatures in the range of about 50-80°C produced typical changes in asymmetry of only about 1%.

In summary, this example demonstrates that we have been able to fabricate reproducible, stable single-layer YAO LR coatings on InP-InGaAsP laser facets.

It is to be understood that the above-described arrangements are merely illustrative of the many possible specific embodiments which can be devised to represent application of the principles of the invention. Numerous and varied other arrangements can be devised in accordance with these principles by those skilled in the art without departing from the spirit and scope of the invention. In particular, YAO coatings may be useful on the output surface of LEDs (in which case the relevant λ is the emission wavelength of the LED), or on the input surface of photodetectors (in which case the relevant λ is the detection/received wavelength of the photodetector), or on the input or output surface of a semiconductor optical modulator (in which case the relevant λ is the wavelength of the signal being modulated).

## Claims

1. An hermetically packaged active optical device (10) comprising:

    a region (20,22,24) of semiconductor material, a coating (14) disposed on said region and through which optical radiation propagates, CHARACTERIZED IN THAT
    said coating comprises an oxide of yttrium and aluminum.

2. The device of claim 1 wherein said region includes an active region (20) of said device, and said coating is a single layer comprising an oxide of yttrium and aluminum.

3. The device of claim 2 wherein said coating is e-beam evaporated from source material comprising yttrium aluminum garnet.

4. The device of claim 1 wherein said region comprises Group III-V compound material.

5. The device of claim 4 wherein said region comprises a surface formed by the edges of a plurality of InP and InGaAsP layers.

6. The device of claim 5 wherein the effective refractive index of said region is about 3.2.

7. The device of claim 6 wherein said region comprises the output facet of a semiconductor laser.

8. A hermetically packaged semiconductor laser (10) capable of emitting radiation at a wavelength λ, said laser comprising:

    an output facet (18) formed by the edges of a plurality of InP and InGaAsP layers, and
    a low reflectivity coating (14) formed on said facet, **characterized in that**
    said coating is a single layer comprising an oxide of yttrium and aluminum having a refractive index $n_c$ and a thickness substantially equal to $m\lambda/4n_c$, where $\underline{m}$ is an odd integer.

*FIG. 1*

*FIG. 2*

$\Delta$ = % DEVIATION FROM QUARTER WAVE THICKNESS

European Patent
Office

**EUROPEAN SEARCH REPORT**

Application Number

EP 97 30 9506

| Category | Citation of document with indication, where appropriate, of relevant passages | Relevant to claim | CLASSIFICATION OF THE APPLICATION (Int.Cl.6) |
|---|---|---|---|
| X | US 4 809 293 A (DEBELL GARY W ET AL)<br>* claims * | 1,2,7 | H01L33/00<br>H01L31/0216<br>H01S3/025<br>G02B1/10 |
| A | EP 0 168 165 A (BRITISH TELECOMM)<br>* the whole document * | 1-8 | |
| A,D | US 4 749 255 A (CHAKRABARTI UTPAL K ET AL)<br>* the whole document * | 1-8 | |
| A | PATENT ABSTRACTS OF JAPAN<br>vol. 007, no. 248 (C-193), 4 November 1983<br>& JP 58 135200 A (KAGAKU GIJIYUTSUCHIYOU MUKIZAISHITSU KENKYUSHO), 11 August 1983,<br>* abstract * | 1,3 | |
| A | PAWEWICZ W T ET AL: "HIGH BAND GAP OXIDE OPTICAL COATINGS FOR 0.25 AND 1.06 MUM FUSION LASERS"<br>THIN SOLID FILMS,<br>vol. 73, no. 1, 3 November 1980,<br>pages 169-175, XP000647424<br>* page 172, paragraph 3.2 * | 1,3 | TECHNICAL FIELDS SEARCHED (Int.Cl.6)<br><br>H01L<br>G02B |

The present search report has been drawn up for all claims

| Place of search | Date of completion of the search | Examiner |
|---|---|---|
| THE HAGUE | 3 March 1998 | Lina, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)